Europäisches Patentamt

European Patent Office

Office européen des brevets

(19)

(11) Publication number: **0 054 571**
**B1**

(12) **EUROPEAN PATENT SPECIFICATION**

(45) Date of publication of patent specification: **08.05.85**

(21) Application number: **81901676.7**

(22) Date of filing: **15.06.81**

(86) International application number:
**PCT/JP81/00138**

(87) International publication number:
**WO 82/00073 07.01.82 Gazette 82/01**

(51) Int. Cl.⁴: **H 04 B 9/00,** H 03 G 3/20,
H 01 L 31/10

(54) **LIGHT RECEIVING CIRCUIT.**

(30) Priority: **25.06.80 JP 85246/80**

(43) Date of publication of application:
**30.06.82 Bulletin 82/26**

(45) Publication of the grant of the patent:
**08.05.85 Bulletin 85/19**

(84) Designated Contracting States:
**DE FR GB NL**

(56) References cited:
**JP-A-53 058 748**
**JP-A-53 059 345**
**JP-A-53 090 802**

**Bell System Technical Journal, July-August
1978 P 1838-1844**

(73) Proprietor: **FUJITSU LIMITED**
**1015, Kamikodanaka Nakahara-ku
Kawasaki-shi Kanagawa 211 (JP)**

(72) Inventor: **MINAMI, Takatoshi**
**1549-1-303, Kamikodanaka Nakahara-ku
Kawasaki-shi, Kanagawa 211 (JP)**
Inventor: **NISHIMOTO, Hiroshi**
**2-1-2, Fujigaoka Midori-ku
Yokohama-shi, Kanagawa 227 (JP)**

(74) Representative: **Muir, Ian R. et al
HASELTINE LAKE & CO. Hazlitt House 28
Southampton Buildings Chancery Lane
London WC2A 1AT (GB)**

Courier Press, Leamington Spa, England.

# Description

This invention relates to a light-receiving circuit for use in repeaters and terminals etc., in optical transmission systems.

A plurality of repeaters is used in optical transmission systems for transmitting light signals to remote terminals. A repeater converts a received light signal into an electrical signal and re-converts it again into a light signal, after waveform equalization and shaping, for transmission to the next repeater. In the terminal station, on the other hand, the received light signal is converted into an electrical signal and thereafter demodulation is carried out.

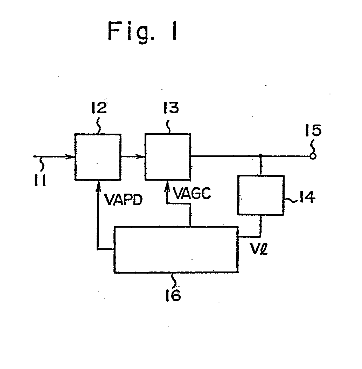

Automatic gain control (AGC) is carried out at the repeaters and terminals so that an electrical signal of substantially constant level can be obtained despite changes in the received light signal level. Figure 1 of the accompanying drawings shows an ordinary light-receiving circuit incorporating an automatic gain control circuit. In this figure, 11 represents a light signal; 12 is an avalanche photo diode (APD); 13 is an amplifier; 14 is a level detector; 15 is the output terminal; 16 is an AGC circuit.

The following methods are currently proposed for executing the AGC using the circuit shown in Fig. 1.

(a) Only the multiplication factor M of APD 12 is controlled, e.g. when the light input level is doubled, the M of the APD is reduced to a half (1/2).

(b) The method (a) is used for low light input levels and then the M of the APD is fixed for high light input levels and the gain of amplifier 13 is controlled.

(c) As is proposed in the published unexamined Japanese patent application No. 53-58748, the method (a) is used for low light input levels, and the gain of amplifier 13 is changed step by step for high light input levels and simultaneously the M of the APD 12 is also controlled.

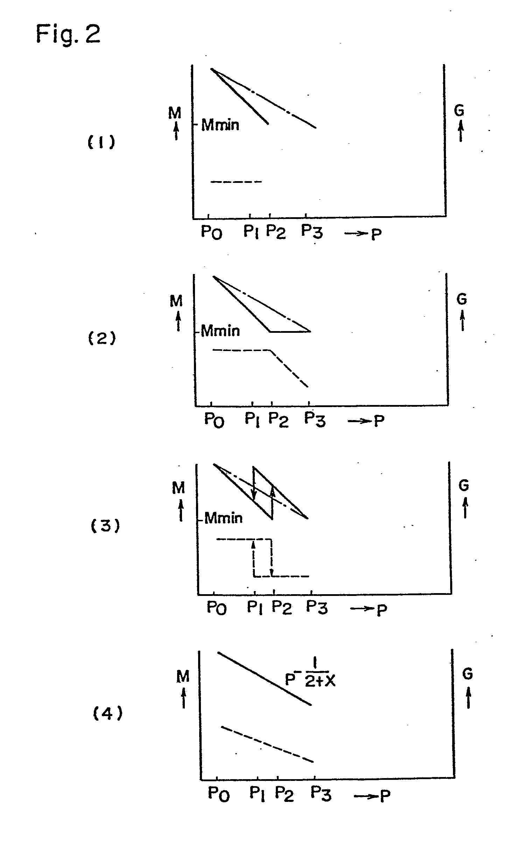

The methods listed above will contribute to the provision of an electrical output signal of substantially constant level despite changes in the received light signal level. Figures 2(1) to 2(3) show the relation between the light input level P, M of the APD 12 and gain G of the amplifier 13 in the methods (a) to (c) given above. In the same figures, the solid line indicates M, the broken line indicates G and the chained line indicates the optimum value of M as will be explained later. $M_{min}$ is the minimum value of the applicable multiplication factor of the APD. When $M < M_{min}$, it is not practical because the response speed of the APD becomes very low as a result of an increase of the capacitance.

The signal to noise ratio (SNR) of the signal at the output of amplifier 13 is basically given by the following equation.

$$SNR = (I_o PM)^2 / (N_s PM^{2+x} + Nth) \qquad (1)$$

Where,
$I_o$ = APD output current for unit light input (when M=1)
P = APD light input power
M = APD multiplication factor
$N_s$ = APD shot noise current power for unit light input (when M=1)
x = Excessive noise figure of APD
Nth = Converted input noise current power of the next stage amplifier of APD.

Equation (1) shows that the SNR depends on P and M and the optimum value $M_o$ of M gives the maximal point of SNR. From equation (1), the dependency on light input level of $M_o$ is expressed as follows.

$$M_o = \left( \frac{2}{x} \cdot \frac{Nth}{Nsp} \right)^{1/(2+x)} \qquad (2)$$

Therefore,

$$M_o \alpha P^{-1/(2+x)} \qquad (3)$$

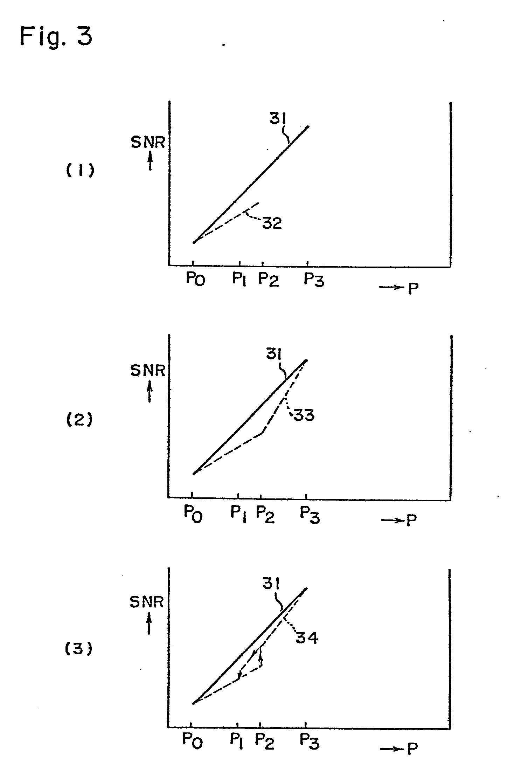

Usually, x is selected as a value ranging from 0.3 to 1. The gain G of the amplifier is automatically determined corresponding to $M_o$ from the condition that the output of the amplifier is to be maintained at a substantially constant level and the so determined gain is the optimum value. The SNR is deteriorated if solely the electrical output signal level is kept at a substantially constant level, since there will be a difference between the M, which keeps the electrical signal at a constant level, and said optimum value $M_o$. Figures 3(1), 3(2) and 3(3) show such conditions.

The figures show the relation between change in light input and the SNR corresponding to the above-mentioned methods (a), (b) and (c). The solid line in the figure shows the ideal values, while the broken lines 32, 33, 34 respectively show the value for the gain control methods (a), (b) and (c). The solid line 31 and broken lines 32, 33, 34 cross at the point $P_o$, and the solid line 31 and the broken lines 33, 34 cross at the point $P_3$ since as shown in Figures 2(1), 2(2), 2(3), the curve for M crosses the optimum value $M_o$ curve at the points $P_o$ and $P_3$. At point $P_o$, M becomes equal to $M_o(M=M_o)$ by setting, while at point $P_3$, M also becomes equal to $M_o$.

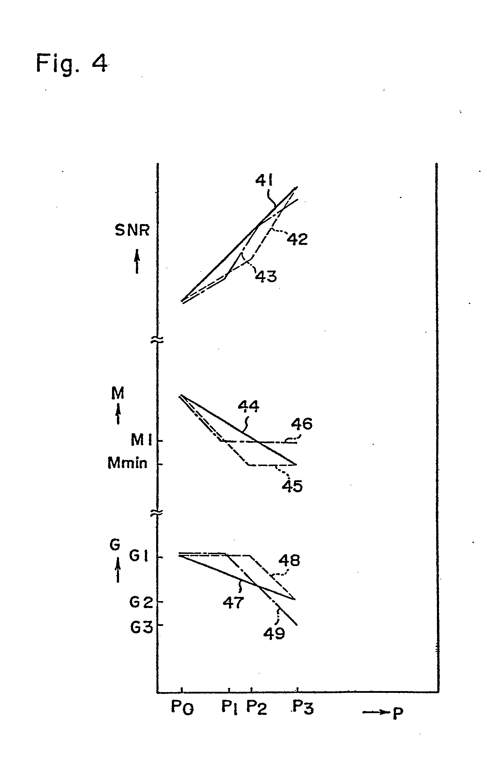

In a method currently being employed to improve the SNR, the value of M is not lowered as far as $M_{min}$ but always kept at a value which is equal to or larger than a value $M_1$ ($>M_{min}$). Thereby, before the SNR deviates largely from the value $SNR_o$ for the condition $M=M_o$, M is limited by $M_1$ and the SNR is improved. This is shown in Fig. 4 together with an example of method (b). In the same figure, the solid lines 41, 44 and 47 show the ideal conditions, while the broken lines 42, 45, 48 show the conditions resulting from method (b), and the chained lines 43, 46, 49 show the condition where M is not allowed to fall below $M_1$.

However, this method where M is not allowed to fall lower than $M_1$ has the following disadvantage. Namely, since the minimum value of M becomes $M_1$ ($>M_{min}$), the required gain variation width is increased as much as ($M_1/M_{min}$) in order to obtain the necessary dynamic range. As can be seen from Fig. 4, when $M>M_{min}$, the amplifier gain width required only ranges from G1 to G2, but when $M>M_1$, it must range from G1 to $G_3$ ($G_2>G_3$).

As proposed in the unexamined published Japanese patent application No. 53-90802, it is possible to simultaneously control the M of the APD and the gain of amplifier in combination so that the M of APD always satisfies equation (3) as shown in Fig. 2 (4) for variation of the light signal input level, but this arrangement has the disadvantage that the control circuit is complicated.

The present invention seeks to provide a light-receiving circuit without the mentioned disadvantages or with disadvantages to a lesser extent.

According to the present invention there is provided a light-receiving circuit including an avalanche photo diode for receiving a light signal and converting it into an electrical signal and an amplifier for amplifying the electrical signal, wherein, to maintain the amplifier output substantially constant irrespective of variation in the light signal input, means are provided to generate voltage control signals to control both the gain of the amplifier and the multiplying factor of said photo diode, characterised in that said means comprises:

a voltage generator circuit for generating a multiplying factor control signal for said photo diode; a first comparator connected to compare voltages derived from the photo diode control signal and from a first reference voltage source and the output of which is connected to an input circuit for the photo diode control signal; a second comparator coupled to compare an output from said amplifier and a voltage from a second reference voltage source and the output of which is coupled to a gain control input circuit of said amplifier; a switching device coupled to receive output from said second comparator and the output of which is coupled to said voltage generator circuit; and a third comparator coupled to compare an output from said second comparator and a voltage from a third reference voltage source and the output of which is coupled to said first reference voltage source; and that the arrangement and reference voltages are such that as light signal increases from a low level, the output of said second comparator coupled via the switching device causes the control signal from the voltage generator circuit to reduce the multiplying factor of the photo diode until a particular light signal level is reached at which said switching device ceases to pass the second comparator output to the voltage generator circuit; a further light signal increase causes the second comparator circuit output to reduce the gain of the amplifier whilst the multiplying factor remains substantially constant until a second particular light signal level is reached; whereafter output from the third comparator to the first reference voltage source causes the first comparator to reduce the photo diode multiplication factor until a third light level is reached at which the variation in the output of the third comparator ceases and the photo diode multiplication factor is held substantially constant; and further light signal increase causes further reduction of the gain under control of the output voltage from the second comparator; so that the photo diode multiplication factor varies over the control range as a polygonal line approximating the multiplication factor line to satisfy the optimum signal to noise ratio for said avalanche photo diode and the automatic gain control of the amplifier in combination with the variation of the multiplication factor holds the output voltage of the light-receiving circuit substantially constant.

Further advantageous embodiments are described in broad terms in the claims.

For a further understanding of the invention reference will now be made, by way of example, to the accompanying drawings, in which:

Figure 1 is a block diagram of a light-receiving circuit;

Figure 2 shows characteristics indicating the relationship between the multiplying factor M of an APD for varying light input and the gain G of an amplifier in different methods of conventional gain control of the light-receiving circuit of Fig. 1;

Figure 3 is a characteristic indicating the relationship between light signal input and signal to noise ratio (SNR) for each method of Fig. 2;

Figure 4 is a characteristic indicating the relation between light input and SNR/M/ and G;

Figure 5 is the schematic diagram of a light-receiving circuit according to the present invention;

Figure 6 shows the variation of voltages, M and G, for varying light signal input for the circuit shown in Fig. 5;

Figure 7 is a characteristic showing the relation between SNR, M and G, for varying light signal input for the circuit shown in Fig. 5;

Figure 8 shows the relationship between $V_{APD}$ and M of an APD;

Figure 9 shows the relationship between $V_{AGC}$ and G of a light-receiving circuit amplifier;

Figure 10 shows the relationship between an input voltage $V_7$ and output voltage $V_{APD}$ of a high voltage generator circuit;

Figure 11 shows a second embodiment of the present invention;

Figure 12 are graphs for explanation of the operation of the circuit of Fig. 11;

Figure 13 shows a third embodiment of the present invention; and

Figure 14 are graphs for use in explaining the operation of Figure 13.

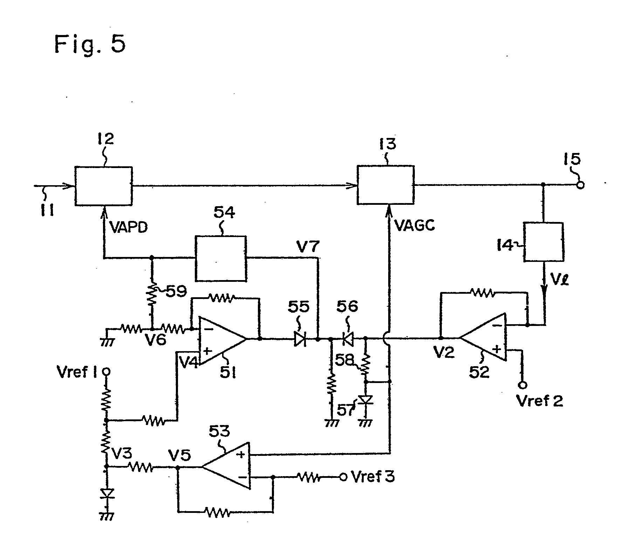

Preferred embodiments of the present invention will be explained with reference to Figures 5 to 14.

Figure 5 is a circuit diagram of one embodiment. of the present invention. In this figure a light signal input 11 is applied to an avalanche photo diode (APD) 12 and the APD output is amplified by an amplifier 13 and fed to the output terminal 15. The output of the amplifier 13 is fed to the level detector 14 and an output voltage $V_1$ of the level detector 14 is connected to the inverted input of a 2nd comparator 52, consisting of a differential amplifier. To the non-inverted input of the 2nd comparator 52, a 2nd reference voltage $V_{ref2}$ is applied. An output voltage $V_2$ of the 2nd comparator 52 is connected to the AGC control terminal input of the amplifier 13, via the resistor 58, supplying the automatic gain control voltage $V_{AGC}$ thereto.

The output of the 2nd comparator 52 is also connected to a switch device, consisting of a diode 56, the output of which forms an input voltage $V_7$ for a high voltage generator circuit 54. An output voltage $V_{APD}$ of the high voltage generator circuit 54 is input to the APD 12 and simultaneously $V_{APD}$ is divided into a voltage $V_6$, via the resistor 59, that is applied to the inverted input of a 1st comparator 51, also consisting of a differential amplifier. To the non-inverted input of the 1st comparator 51, a voltage $V_4$ obtained by division from a 1st reference voltage $V_{ref1}$ is applied. An output of the 1st comparator 51 is input to the high voltage generator circuit 54 via a switch device consisting of the diode 55.

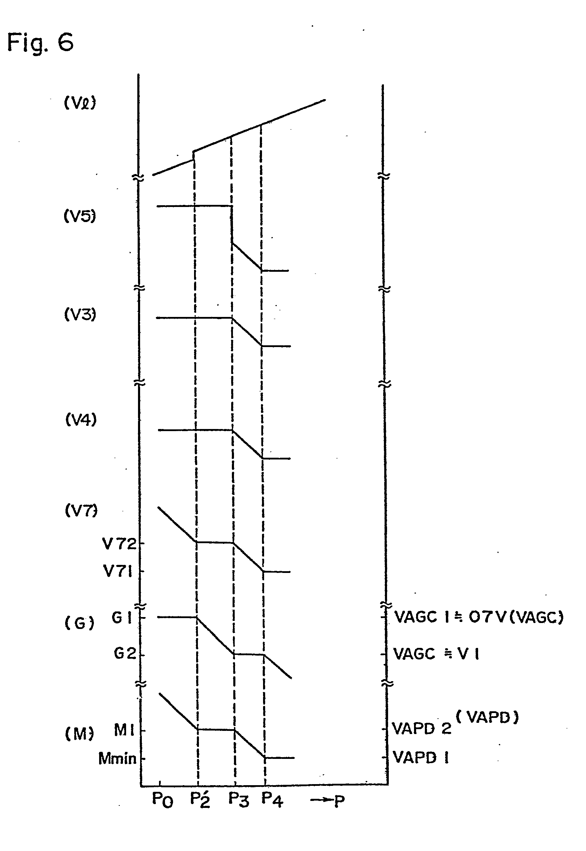

The voltage $V_{AGC}$ is also supplied to the non-inverted input of a 3rd comparator 53, consisting of a differential amplifier, whilst a 3rd reference voltage $V_{ref3}$ is applied to the inverted input. An output voltage $V_5$ of this 3rd comparator 53 determines a voltage $V_4$ in combination with the 1st reference voltage $V_{ref1}$. The operation of the circuit of Fig. 5 will be explained with reference to Fig. 6. In a starting condition with a low light input signal level $P_o$, M is adjusted to the optimum value and the gain G of amplifier 13 is the maximum. When the light input gradually increases, the voltage $V_1$ at the output of 14 rises as shown in the figure. Resultingly, the output voltage $V_2$ of the 2nd comparator gradually reduces. Since the voltage $V_2$ is at this stage positive, it is applied to the high voltage generator circuit 54 passing the diode 56, and thereby a voltage $V_{APD}$ is obtained as the output of circuit 54. The voltage $V_{APD}$ also reduces as the voltage $V_2$ reduces. Thus, M of the APD also reduces.

The voltage $V_{APD}$ reduces until the voltage $V_6$ divided from the voltage $V_{APD}$ reaches the voltage $V_4$ divided from the 1st reference voltage $V_{ref1}$. This is arranged to occur when the light input level reaches $P_2'$. Also, at this light level $V_2$ changes from positive to negative. When the voltage $V_6$ reaches the voltage $V_4$, a positive voltage is output to the output of the 1st comparator and thereby the diode 55 turns ON, forming the loop through the 1st comparator 51 and the high voltage generator circuit 54, keeping the $V_{APD}$ at a constant level. Therefore, the value of M becomes a constant.

As explained above, the voltage $V_2$ is positive until the light input level reaches the point $P_2'$ of Fig. 6 as shown above and until this point $V_{AGC}$ is clamped by the diode 57. However, when the light input increases further causing the voltage $V_1$ to rise and the voltage $V_2$ reduces to a negative voltage, the voltage $V_{AGC}$ reduces and thereby the gain G of the amplifier 13 also reduces. When the light input further increases and reaches $P_3$, voltage $V_2$ corresponds to the 3rd reference voltage $V_{ref3}$. Thus, the polarity of the output voltage $V_5$ of the 3rd comparator 53 changes from positive to negative, causing the voltage $V_3$ to change to negative. When the light input level reaches the level $P_4$, the output voltage $V_5$ of comparator 53 reaches a saturation value and stays constant despite further light level increase. Between $P_3$ and $P_4$ the voltage $V_3$ is reduced until the voltage $V_5$ reaches this negative saturation level. Resultingly, the voltage $V_4$ reduces according to it until a value corresponding to the saturation level of the voltage $V_5$. Thereby, the $V_{APD}$ and the value of M reduce in the same way, and when M reaches a constant value corresponding to the saturation level of $V_5$, it stays fixed to such a value. When the value of M is fixed to this constant value, the $V_{AGC}$ is further reduced and the gain G is also lowered. When a light input level is within the range $P_3$ to $P_4$, the gain G does, of course, reduce since the $V_{AGC}$ reduces, but the gain reduction is as small as 1/(gain of comparator 53) as compared with variation of M, and therefore the gain is indicated as a constant value for simplification of explanation.

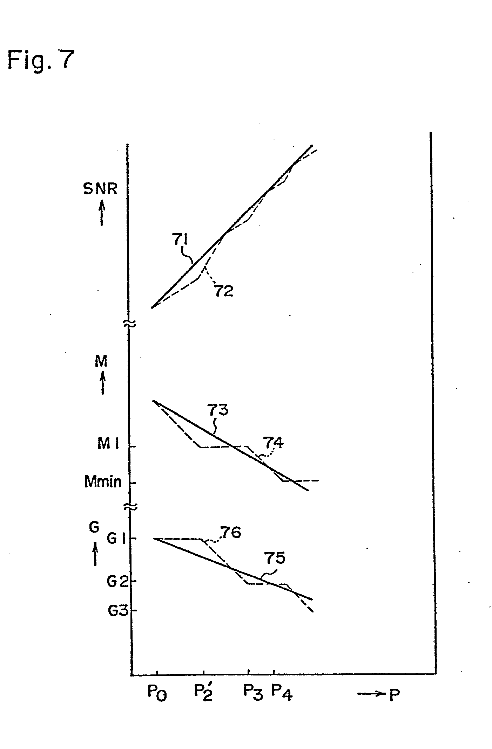

Figure 7 shows with the solid lines 71, 73, 75, the optimum values of SNR, M and G with varying light input, and also shows the approximate values obtained by the light-receiving circuit of the embodiment of the present invention, by means of the broken lines 72, 74 and 76.

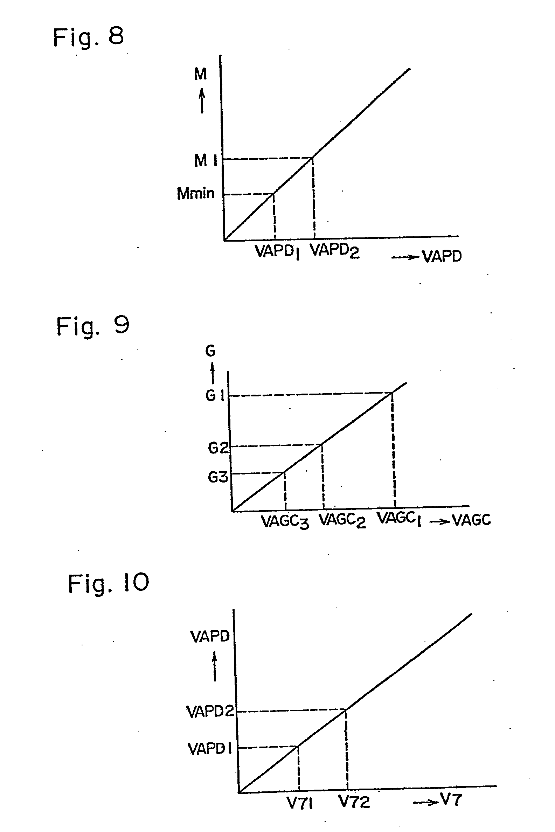

Figure 8 is a characteristic indicating an example of the relationship between $V_{APD}$ and M of APD 12. Figure 9 is a characteristic indicating an example of the relationship between $V_{AGC}$ and the gain G of amplifier 13. Figure 10 shows a characteristic indicating the relation between the input voltage $V_7$ and output voltage $V_{APD}$ of the high voltage generator circuit 54.

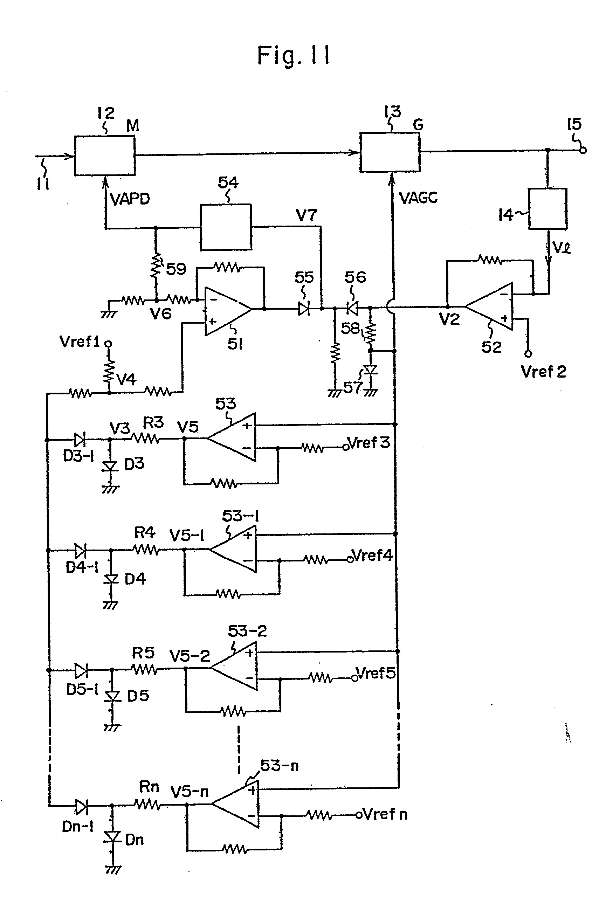

In the above embodiment, the multiplication factor M of the APD is approximated to the optimum value $M_o$ by a polygonal line having three turning points (the gain G is automatically approximated to the ideal condition), but it is also possible to obtain a modification of the embodiment which more approximates the SNR to the optimum value by additionally providing in parallel a plurality of the 3rd comparators as shown in Fig. 11 and by setting the reference voltages corresponding to one 3rd reference voltage of these comparators to different values.

Namely, the comparators 53-1, 53-2 to 53-n are provided in parallel with the comparator 53, and the reference voltages $V_{ref4}$, $V_{ref5}$ to $V_{refn}$ are input to the inverted inputs thereof, whilst $V_{AGC}$ is input to the non-inverted inputs. The outputs of the comparators 53-1 to 53-n are connected with the resistors $R_4$, $R_5$ to $R_n$, diodes $D_4$ to $D_n$, and diodes $D_{4-1}$ to $D_{n-1}$. Here, the voltages $V_{ref3}$, $V_{ref4}$, $V_{ref5}$ to $V_{refn}$ are in the following relation as

$$V_{ref3} > V_{ref4} > V_{ref5} \ldots \rightarrow V_{refn},$$

while the resistors $R_3$, $R_4$, $R_5$ to $R_n$ are in the relation as $R_3 > R_4 > R_5 > R_n$. The circuit operation is explained below.

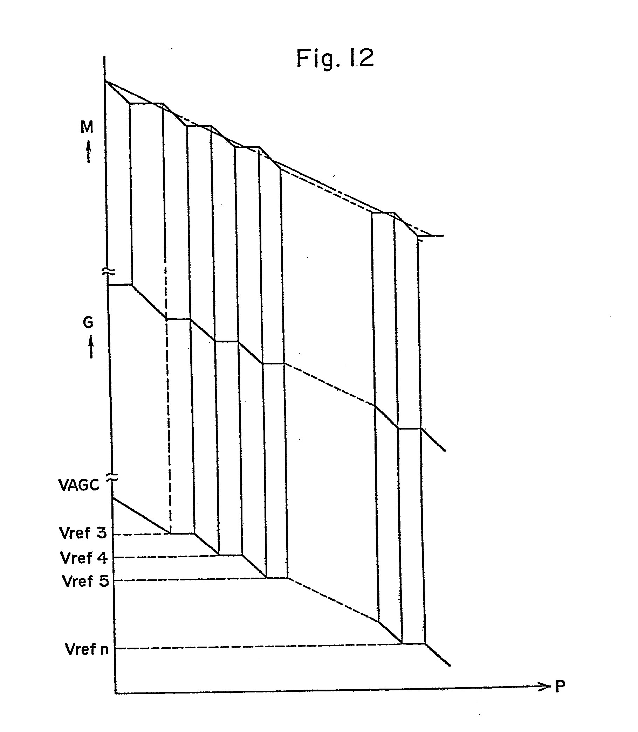

The steps up to saturation of the output voltage of the comparator 53 are the same as that of the circuit shown in Fig. 5. When $V_{AGC}$ is lowered further than the reference voltage $V_{ref4}$ as shown in Fig. 12, an output voltage $V_{5-1}$ of the comparator 53-1 becomes negative and thereby the voltage $V_4$ is also lowered. Since voltage $V_4$ is lowered until the output voltage $V_{5-1}$ reaches saturation value, $V_{APD}$ is also lowered in accordance with the voltage $V_4$. Resultingly, M is also lowered until the output voltage $V_{5-1}$ saturates. M then keeps at a constant value until the voltage $V_{AGC}$ becomes lower than the reference voltage $V_{ref5}$ and, thereafter, it is further lowered in the same way until $V_{5-2}$ reaches saturation value; and so on. The chained line in Fig. 12 indicates the optimum value of M and the solid line the actual value.

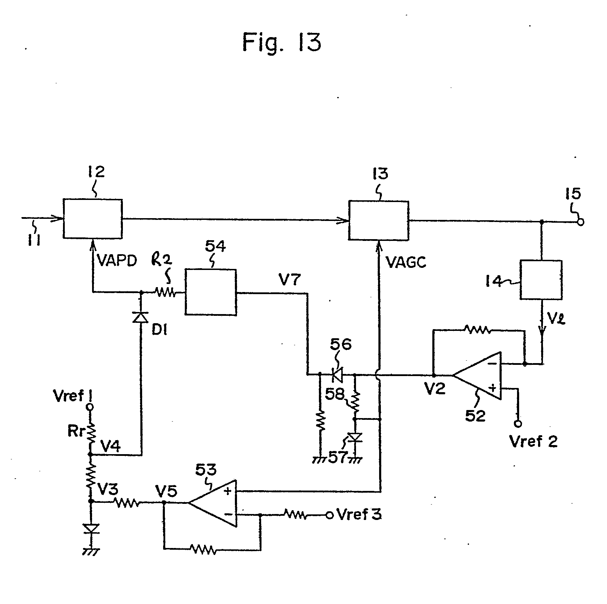

Figure 13 shows another embodiment of the present invention. The circuit indicated has the same function as the circuit shown in Fig. 5. The only difference from the circuit of Fig. 5 is that the comparator 51, diode 55 and resistor 59 are removed, and an output of the high voltage generator circuit 54 is connected to the resistor $R_2$, which is connected to the reference power supply $V_{ref1}$, via the diode $D_1$ (which forms a first comparator corresponding to 51).

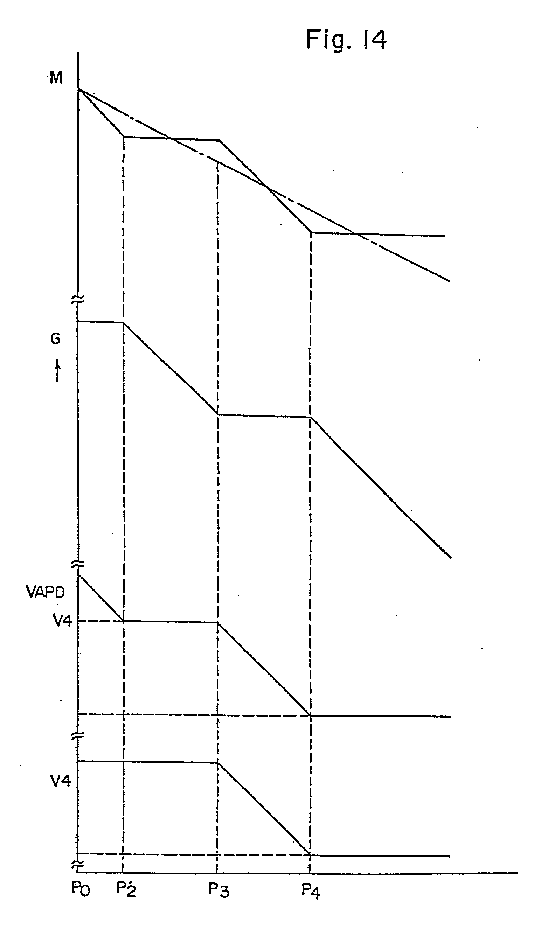

The Fig. 13 circuit operation will be explained by referring to Fig. 14. When the light input level is low, the voltage V is lower than the reference voltage $V_{ref2}$. Therefore, the output voltage $V_2$ of the comparator 52 is positive and is applied to the high voltage generator circuit 54 as the voltage $V_7$ via the diode 56. When the light input level becomes higher, the voltage $V_7$ is lowered and also the voltage $V_{APD}$ becomes low. When the light input level reaches $P_2'$, the voltage $V_I$ becomes equal to the reference voltage $V_{ref2}$, the output voltage $V_2$ becomes negative and the switch or diode 56 turns OFF and the voltage $V_{APD}$ becomes equal to the voltage $V_4$, the voltage $V_{APD}$ is thus clamped to $V_4$. Thereby, M becomes constant and the gain G is lowered by increasing light signal since the voltage $V_{AGC}$ becomes low with $V_2$. When the light signal input exceeds the level $P_3$, the voltage $V_{AGC}$ becomes lower than the reference voltage $V_{ref3}$. Thus, the output voltage $V_5$ becomes negative and the voltage $V_4$ becomes low. Thereby, the voltage $V_{APD}$ becomes also low according to the voltage $V_4$ and M becomes small again. When the light input reaches $P_4$, the output voltage $V_5$ is saturated and thereafter M becomes constant. Only the voltage $V_{AGC}$ becomes low with further light signal increase and the gain G also becomes small. Thus, M can be approximated to the optimum values indicated by the chained line in Fig. 14.

As will be obvious from the above explanation, the present invention provides a light-receiving circuit with a simple structure which can assure wide light input dynamic range without allowing the SNR to be deviated largely from the optimum value and without needing the desired variable gain width of the amplifier to be widened.

## Claims

1. A light-receiving circuit including an avalanche photo diode (12) for receiving a light signal and converting it into an electrical signal and an amplifier (13) for amplifying the electrical signal, wherein, to maintain the amplifier output substantially constant irrespective of variation in the light signal input, means (16) are provided to generate voltage control signals to control both the gain of the amplifier (13) and the multiplying factor of said photo diode (12), characterised in that said means comprises:

a voltage generator circuit (54) for generating a multiplying factor control signal for said photo diode (12); a first comparator (51; D1) connected to compare voltages derived from the photo diode control signal and from a first reference voltage source (V ref. 1) and the output of which is connected to an input circuit (VAPD; 55, 54, VAPD) for the photo diode control signal; a second comparator (52) coupled to compare an output from said amplifier (13) and a voltage from a second reference voltage source (V ref. 2) and the output of which is coupled to a gain control input circuit (VAGC) of said amplifier (13); a switching device (56) coupled to receive output from said second comparator (52) and the output of which is coupled to said voltage generator circuit (54); and a third comparator (53) coupled to compare an output from said second comparator (52) and a voltage from a third reference voltage source (V ref. 3) and the output of which is coupled to said first reference voltage source (V ref. 1);

and that the arrangement and reference voltages are such that as light signal increases from a low level, the output of said second comparator (52) coupled via the switching device (56) causes the control signal from the voltage generator circuit (54) to reduce the multiplying factor of the photo diode (12) until a particular light signal level is reached at which said switching device (56) ceases to pass the second comparator output to the voltage generator circuit (54); a further light signal increase causes the second comparator circuit (52) output to reduce the gain of the amplifier (13) whilst the multiplying factor remains substantially constant until a second particular light signal level is reached; whereafter output from the third comparator to the first reference voltage source causes the first comparator to reduce the photo diode multiplication factor until a third light level is reached at which the variation in the output of the third comparator ceases and the photo diode (12) multiplication factor is held substantially constant; and further light signal increase causes further reduction of the gain under control of the output voltage from the second comparator; so that the photo diode multiplication factor varies over the control range as a polygonal line approximating the multiplication factor line to satisfy the optimum signal to noise ratio for said avalanche photo diode and the automatic gain control of the amplifier (13) in combination with the variation of the multiplication factor holds the output voltage of the light-receiving circuit substantially constant.

2. A light-receiving circuit according to claim 1, wherein the first (51), second (52) and third (53) comparators are each constituted by a respective differential amplifier; said voltage derived from the photo diode control signal is fed to the first comparator (51) inverted input; said output from amplifier (13) is fed to the second comparator (52) inverted input; said third reference voltage source (Vref3) voltage is fed to the third comparator (53) inverted input; and the voltage derived from the first reference voltage source (Vref1), said second reference voltage source (Vref2) voltage, and said output from said second comparator (52) are connected to the non-inverted inputs of said first (51), second (52), and third (53) comparators respectively.

3. A light-receiving circuit according to claim 1, wherein a plurality of third comparators (53; 53-1; 53-2; ... 53-n) are provided, each connected to compare said output from the second comparator (52) with respective different voltages from third reference voltage sources (Vref3, Vref4, Vref5 ... Vrefn) and each having its output coupled to said first reference voltage source (Vref1).

4. A light-receiving circuit according to claim 3, wherein each of said third comparators is constituted by a respective differential amplifier (53; 53-1; ... 53-n) and the voltages from said third reference voltage sources (Vref3, ... Vrefn) are connected to the respective inverted input terminals and said output from the second comparator (52) is connected to the non-inverted input terminals.

5. A light-receiving circuit according to claim 1, wherein said first comparator is constituted by a diode (D1) with its anode connected to said first reference voltage source and its cathode connected to said photo diode (12) input circuit (VAPD); said second and third comparators are each constituted by a respective differential amplifier (52, 53); said output from amplifier (13) and said voltage from the third reference voltage source are fed to the respective inverted input of the comparators; and said voltage from the second reference voltage source and output from said second comparator are fed to the respective non-inverted input of the comparators.

6. A light-receiving circuit according to any preceding claim wherein said switching device (56) is a diode which passes said output from said second comparator (52) until blocked by a reversal of polarity thereacross.

**Revendications**

1. Circuit de réception de lumière comportant une photodiode de type avalanche (12) servant à recevoir un signal lumineux et à la transformer en un signal électrique et un amplificateur (13) servant à amplifier le signal électrique, où, pour maintenir le niveau de sortie de l'amplificateur sensiblement constant quelles que soient les variations du signal lumineux d'entrée, des moyens (16) sont prévus pour produire des signaux de commande de tension afin de commander à la fois le gain de l'amplificateur (13) et le facteur de multiplication de ladite photodiode (12), caractérisé en ce que

lesdits moyens comprennent: un circuit (54) générateur de tension servant à produire un signal de commande du facteur de multiplication pour ladite photodiode (12); un premier comparateur (51; D1) qui est connecté de façon à comparer des tensions déduites du signal de commande de la photodiode et d'une source d'une première tension de référence (Vkef.1) et dont la sortie est connectée à un circuit d'entrée (VAPD; 55, 54, VAPD) pour le signal de commande de la photodiode; un deuxième comparateur (52) qui est connecté de façon à comparer le signal de sortie dudit amplificateur (13) et la tension d'une source de deuxième tension de référence (Vref.2) et dont la sortie est connectée à un circuit d'entrée de commande de gain (VAGC) dudit amplificateur (13); un dispositif de commutation (56) qui est connecté de façon à recevoir le signal de sortie dudit deuxième comparateur (52) et dont la sortie est connectée audit circuit (54) générateur de tension; et un troisième comparateur (53) qui est connecté de façon à comparer le signal de sortie dudit deuxième comparateur (52) et la tension d'une source de troisième signal de référence (Vref.3) et dont la sortie est connectée à ladite source de première tension de référence (Vref.1);

et en ce que le montage et les tensions de référence sont tels que: lorsque le signal lumineux augmente à partir d'un niveau bas, le signal de sortie dudit deuxième comparateur (52) appliqué via le circuit de commutation (56) amène le signal de commande du circuit (54) générateur de tension à réduire le facteur de multiplication de la photodiode (12) jusqu'à ce qu'un niveau particulier du signal lumineux soit atteint, pour lequel ledit dispositif de commutation (56) cesse de laisser parvenir le signal de sortie du deuxième comparateur jusqu'au circuit (54) générateur de tension; une nouvelle augmentation du signal lumineux amène le signal de sortie du deuxième circuit comparateur (52) à réduire le gain de l'amplicateur (13), tandis que le facteur de multiplication reste sensiblement constant jusqu'à ce qu'un deuxième niveau particulier du signal lumineux soit atteint; après quoi le signal de sortie du troisième comparateur appliqué à la source de première tension de référence amène le premier comparateur à réduire le facteur de multiplication de la photodiode jusqu'à ce qu'un troisième niveau du signal lumineux soit atteint, pour lequel les variations du signal de sortie du troisième comparateur cessent et le facteur de multiplication de la photodiode (12) est maintenu sensiblement constant; et une nouvelle augmentation du signal lumineux amène une nouvelle réduction du gain sous commande de la tension de sortie du deuxième comparateur; si bien que le facteur de multiplication de la photodiode varie sur l'étendue de l'intervalle de commande suivant une ligne polygonale qui approche la ligne du facteur de multiplication permettant d'obtenir le rapport signal-bruit optimal pour ladite photodiode de type avalanche, et la commande automatique de gain de l'amplificateur (13) se combinant avec les variations du facteur de multiplication maintient sensiblement constante la tension de sortie du circuit de réception de lumière.

2. Circuit de réception de lumière selon la revendication 1, où les premier, deuxième et troisième comparateurs (51, 52, 53) sont chacun constitués par un amplificateur différentiel; ladite tension déduite du signal de commande de la photodiode est délivrée à l'entrée d'inversion du premier comparateur (51); ledit signal der sortie de l'amplificateur (13) est délivré à l'entrée d'inversion du deuxième comparateur (52); ladite tension de la source de troisième tension de référence (Vref3) est délivrée à l'entrée d'inversion du troisième comparateur (53); et la tension déduite de la source de première tension de référence (Vref1), ladite tension de la source de deuxième tension de référence (Vref2), et ledit signal de sortie dudit deuxième comparateur (52) sont respectivement appliquées aux entrées de non-inversion desdits premier, deuxième et troisième comparateurs (51, 52, 53).

3. Circuit de réception de lumière selon la revendication 1, où sont prévus plusieurs troisièmes comparateurs (53; 53-1; 53-2; ... 53-n), qui sont chacun connectés de façon à comparer ledit signal de sortie du deuxième comparateur (52) avec les tensions différentes respectives de sources de troisièmes tensions de référence (Vref3, Vref4, Vref5, ... Vrefn) et dont les sorties sont chacune connectées à ladite source de première tension de référence (Vref1).

4. Circuit de réception de lumière selon la revendication 3, où chacun desdits troisièmes comparateurs est constitué par un amplificateur différentiel (53; 53-1; ...; 53-n) respectif et les tensions de sortie desdites sources de troisièmes tensions de référence (Vref3, ..., Vrefn) sont respectivement appliquées aux bornes d'entrée d'inversion, tandis que ledit signal de sortie du deuxième comparateur (52) est appliqué aux bornes d'entrée de non-inversion.

5. Circuit de réception de lumière selon la revendication 1, où ledit premier comparateur est constitué par une diode (D1) dont l'anode est connectée à ladite source de première tension de référence et la cathode est connectée audit circuit d'entrée (VAPD) de la photodiode (12); lesdits deuxième et troisième comparateurs sont chacun constitués par un amplificateur différentiel (52, 53); ledit signal de sortie de l'amplificateur (13) et ladite tension venant de la source de troisième tension de référence sont respectivement délivrés à l'entrée d'inversion des comparateurs; et ladite tension venant de la source de deuxième tension de référence et ledit signal de sortie du deuxième comparateur sont respectivement délivrés à l'entrée de non-inversion des comparateurs.

6. Circuit de réception de lumière selon l'une quelconque des revendications précédentes, où ledit dispositif de commutation (56) est une diode qui laisse passer ledit signal de sortie dudit deuxième comparateur (52) jusqu'à ce qu'elle soit bloquée par le fait qu'un renversement de polarité est appliqué à ses bornes.

**Patentansprüche**

1. Licht-Empfängerkreis mit einer Lawinenfotodiode (12) zum Empfang eines Lichtsignals und zur Umwandlung desselben in ein elektrisches Signal, und einem Verstärker (13) zur Verstärkung des elektrischen Signals, bei welchem zur Aufrechterhaltung eines im wesentlichen konstanten Verstärkerausgangs, unabhängig von Variationen der Lichtsignaleingabe, Einrichtungen (16) vorgesehen sing, zur Erzeugung von Spannungssteuersignalen zur Steuerung sowohl der Verstärkung des Verstärkers (13) als auch des Multiplikationsfaktors der Fotodiode (12), gekennzeichnet, durch

einen Spannungsgenerator (54) zur Erzeugung eines Multiplikationsfaktor-Steuersignals für die genannte Fotodiode;

einen ersten Komparator (51; D1), welcher angeschlossen ist um die Spannungen zu vergleichen, die von dem Fotodioden-Steuersignal und von einer ersten Referenzspannungsquelle (Vref.1) abgeleitet werden, un dessen Ausgang mit einer Eingangsschaltung verbunden ist (VAPD; 55, 54, VAPD) für das Fotodioden-Steuersignal;

einen zweiten Komparator (52), welcher angeschlossen ist um einen Ausgang von dem Verstärker (13) und eine Spannung von einer zweiten Referenzspannungsquelle (Vref.2) zu vergleichen, und dessen Ausgang mit einer verstärkten Steuereingangsschaltung (VAGC) des genannten Verstärkers (13) verbunden ist;

eine Steuerschalteinrichtung (56), welche angeschlossen ist um einen Ausgang des genannten zweiten Komparators (52) zu empfangen und deren Ausgang mit dem genannten Spannungsgenerator (54) verbunden ist;

und einen dritten Komparator (53), welcher so angeschlossen ist, daß er den Ausgang des genannten zweiten Generators (52) und eine Spannung von einer dritten Referenzspannungsquelle (Vref.3) vergleicht und dessen Ausgang mit der genannten ersten Referenzspannungsquelle (Vref.1) verbunden ist;

und daß die Anordnung und die Referenzspannungen so getroffen sind, daß bei Anwachsen des Lichtsignals von einem niedrigen Pegel, der Ausgang des zweiten Komparators (52), der über die Schalteinrichtung (56) angeschlossen ist, bewirkt, daß das Steuersignal von dem Spannungsgenerator (54) den Multiplikationsfaktor der Fotodiode (12) reduziert, bis ein besonderer Lichtsignalpegel erreicht ist, bei welchem die genannte Schalteinrichtung (56) die Weitergabe des Ausgangs des zweiten Komparators zu dem Spannungsgenerator (54) beendet;

ein weiterer Lichtsignalanstieg bewirkt, daß der Ausgang der zweiten Komparatorschaltung (52) den Verstärkungsfaktor des Verstärkers (13) reduziert, während der Multiplikationsfaktor im wesentlichen konstant bleibt, bis ein zweiter besonderer Lichtsignalpegel erreicht ist,

woraufhin der Ausgang von dem dritten Komparator zu der ersten Referenzspannungsquelle bewirkt, daß der erste Komparator den Fotodiodenmultiplikator reduziert, bis ein dritter Lichtpegel erreicht wird, bei welchem die Variation des Ausgangs des dritten Komparators endet und der Multiplikationsfaktor der Fotodiode (12) im wesentlichen konstant gehalten wird,

und ein weiterer Anstieg des Lichtsignals eine weitere Reduktion der Verstärkung unter der Steuerung der Ausgangsspannung von dem zweiten Komparator bewirkt,

so daß der Fotodiodenmultiplikationsfaktor über den Steuerbereich als ein Polygonzug variiert, welcher die Linie des Multiplikationsfaktors angleicht, um das optimale Signal/Rauschen-Verhältnis für die genannte Lawinenfotodiode zu befriedigen und die automatische Verstärkungssteuerung des Verstärkers (13) in Kombination mit der Veränderung des Multiplikationsfaktors die Ausgangsspannung der Licht-Empfängerschaltung im wesentlichen konstant hält.

2. Licht-Empfängerkreis nach Anspruch 1, bei welchem der erste (51), der zweite (52) und der dritte (53) Komparator jeweils von einem entsprechenden Differenzialverstärker gebildet sind; die Spannung, welche von dem Fotodiodensteuersignal abgeleitet wird, dem invertierten Eingang des ersten Komparators (51) zugeführt wird; der genannte Ausgang von dem Verstärker (13) dem invertierten Eingang des zweiten Komparators (52) zugeführt wird; die genannte dritte Referenzspannung (Vref3) dem invertierten Eingang des dritten Komparators (53) zugeführt wird; und die Spannung, welche von der ersten Referenzspannungsquelle (Vref1), von der genannten zweiten Referenzspannungsquelle (Vref2) und der genannte Ausgang von dem genannten zweiten Komparator (52) den nichtinvertierten Eingängen des ersten (51), zweiten (52) bzw. dritten (53) Komparators zugeführt werden.

3. Licht-Empfängerkreis nach Anspruch 1, bei welchem eine Vielzahl von dritten Komparatoren (53; 53-1; 53-2; . . . 53-n) vorgesehen sind, welche jeweils so angeschlossen sind, daß sie den genannten Ausgang von dem zweiten Komparator (52) mit entsprechend vershiedenen Spannungen von den dritten Referenzspannungsquellen (Vref3, Vref4, Vref5 . . . Vrefn) vergleichen und ihr Ausgang jeweils mit der genannten ersten Referenzspannungsquelle (Vref1) verbunden ist.

4. Licht-Empfängerkreis nach Anspruch 3, bei welchem jeder der dritten Komparatoren von einem entsprechenden Differenzialverstärker (53; 53-1; . . . 53-n) gebildet ist und die Spannung von den genannten dritten Referenzspannungsquellen (Vref3, . . . Vrefn) mit den entsprechenden invertierten Eingangsanschlüssen verbunden sind und der genannte Ausgang von dem zweiten Komparator (52) mit dem nicht-invertierten Eingangsanschluß verbunden ist.

5. Licht Empfängerkreis nach Anspruch 1, bei welchem der genannte erste Komparator von einer Diode (D1) gebildet ist, deren Anode mit der ersten Referenzspannungsquelle und deren Kathode mit der genannten Fotodioden (12) - Eingangsschaltung (VAPD) verbunden sind; die zweiten und die dritten Komparatoren jeweils von einem entsprechenden Differenzialverstärker (52, 53) gebildet sind; der genannte Ausgang des Verstärkers (13) und die genannte Spannung von den dritten Referenzspannungsquellen den entsprechenden invertierten Eingängen der Komparatoren zugeführt werden; und die genannte Spannung von der zweiten Referenzspannungsquelle und der Ausgang von dem genannten zweiten Komparator dem entsprechenden nicht-invertierten Eingang des Komparators zugeführt werden.

6. Licht-Empfängerkreis nach einem der vorhergehenden Ansprüche, bei welchem die genannte Schalteinrichtung (56) eine Diode ist, welche den genannten Ausgang von dem genannten zweiten Komparator (52) solange hindurchläßt, bis sie durch eine Umkehrung ihrer Polarität blockiert wird.

# Fig. I

# Fig. 2

Fig. 3

(1)

SNR

31

32

$P_0$  $P_1$ $P_2$   $P_3$  →P

(2)

SNR

31

33

$P_0$  $P_1$ $P_2$  $P_3$  →P

(3)

SNR

31

34

$P_0$  $P_1$ $P_2$  $P_3$  →P

Fig. 4

# Fig. 5

## Fig. 6

# Fig. 7

Fig. 8

Fig. 9

Fig. 10

# Fig. 11

Fig. 12

## Fig. 13

# Fig. 14